# FASCICULE DE BREVET EUROPEEN

(11) **EP 3 900 499 B1**
(45) Date de publication et mention de la délivrance du brevet: **09.03.2022**
(21) Numéro de dépôt: 19848884.3
(22) Date de dépôt: 19.12.2019
(51) Int. Cl.: H05K 7/14, H05K 3/46, H05K 3/30

(54) **PROCÉDÉ DE FABRICATION D'UNE CARTE ÉLECTRONIQUE DE FOND DE PANIER**
VERFAHREN ZUR HERSTELLUNG EINER ELEKTRONISCHEN RÜCKENPLATINE
PROCESS FOR MANUFACTURING A BACKPANEL ELECTRONIC CARD

(30) Priorité: 21.12.2018 FR 1873975
(43) Date de publication de la demande: 27.10.2021
(73) Titulaire: SAFRAN ELECTRONICS & DEFENSE, 92100 Boulogne Billancourt (FR)
(72) Inventeur: GUILLOT, François, 77550 MOISSY-CRAMAYEL (FR); CHETANNEAU, Patrice, 77550 MOISSY-CRAMAYEL (FR)
(74) Mandataire: Regimbeau
(86) Numéro de dépôt international: PCT/FR2019/053193
(87) Numéro de publication internationale: WO 2020/128355

(56) Documents cités:
- WO-A1-2016/151053
- US-A- 5 601 672
- US-A- 6 090 633
- US-A1- 2005 109 532
- US-A1- 2012 160 547
- US-A1- 2014 353 018

## Description

### DOMAINE TECHNIQUE

Le domaine de l'invention est celui des calculateurs électroniques et en particulier les calculateurs des systèmes embarqués en avionique. Plus précisément, l'invention porte sur le procédé de fabrication d'une carte électronique de fond de panier pour un calculateur de systèmes embarqués en avionique.

### ETAT DE LA TECHNIQUE

Dans les avions modernes, il est connu de relier entre eux les modules de pilotage et/ou de contrôle d'organes fonctionnels de l'avion au travers d'un ou plusieurs bus principaux de l'avion. Ces bus sont couramment des bus spécifiques au domaine de l'aviation, et notamment des bus utilisant les protocoles de bus série distribués de types ARINC 429 ou autres. Ainsi, à titre d'exemple, pour la gestion des éléments mobiles des trains d'atterrissage d'un avion, plusieurs modules de pilotage et/ou de contrôle sont mis en œuvre, ces derniers étant chacun reliés aux bus principaux de l'avion.

Chaque module de pilotage comporte un calculateur 1 mettant en œuvre un programme adapté afin d'assurer la fonction de pilotage auquel il est dédié, ainsi qu'une interface de communication adaptée au protocole du bus principal permettant l'échange de données entre le calculateur et les bus principaux de l'avion.

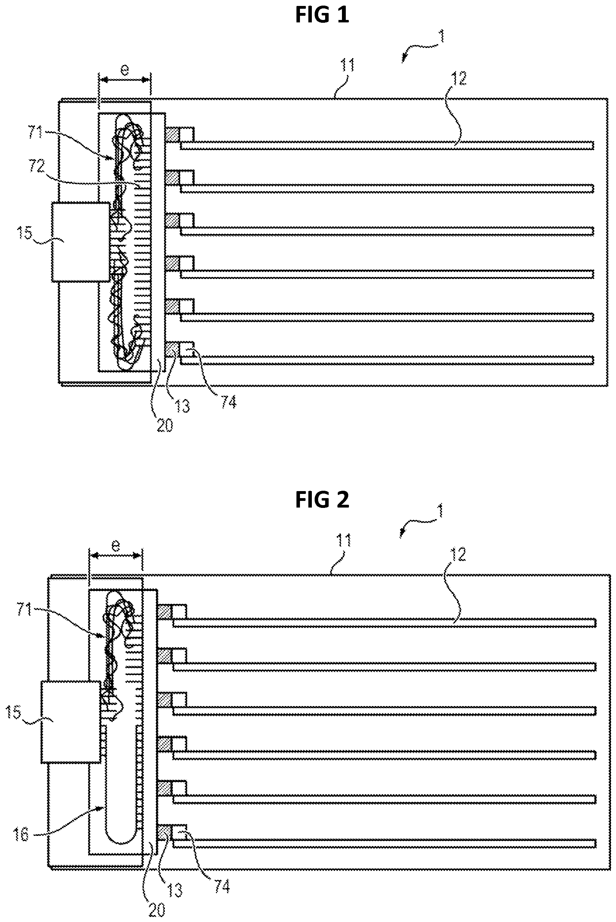

La **figure 1** montre le schéma simplifié d'un calculateur électronique 1. Celui-ci comprend un bâti mécanique 11, une ou plusieurs cartes électroniques 12 et une carte 20 dite carte de 'fond de panier' ou 'backplane' en anglais.

Chaque carte électronique 12 est maintenue mécaniquement dans le bâti 11 par des glissières et connectée à la carte électronique de fond de panier 20. La carte électronique de fond de panier 20 comporte des connecteurs de carte 13 adaptés pour être connectés à un connecteur complémentaire 74 porté par la carte électronique 12.

La carte électronique de fond de panier 20 comporte pour chaque module de pilotage, un connecteur externe 15 adapté pour coopérer avec un connecteur complémentaire porté par le module associé.

Comme illustré sur la **figure 1****,** il est connu de connecter le connecteur externe 15 à la carte électronique de fond de panier 20 par des fils 71 enroulés sur des broches carrés 72 des composants, selon la méthode dite de 'Wrapping' selon la terminologie anglo-saxonne.

La technique de wrapping présente de nombreux inconvénients et notamment un prix de revient excessif, l'obsolescence des composants et des compétences et de médiocres performances de compatibilité électromagnétique.

Un autre inconvénient du wrapping est que l'absence d'adaptation d'impédance et le bruit peuvent générer des phénomènes de réflexion aux fréquences élevées et des défaillances électroniques sur les signaux critiques.

Un autre inconvénient du wrapping est qu'il nécessite une zone de câblage de largeur conséquente qui pénalise la compacité du calculateur 1.

Comme illustré sur la **figure 2****,** il a été proposé d'utiliser une nappe 16 qui est une bande électrique plate (circuit imprimé flexible en nappe), constituée de fils de cuivre collés les uns aux autres, munie d'un connecteur à chacune de ses extrémités pour relier le connecteur externe 15 et la carte électronique de fond de panier 20.

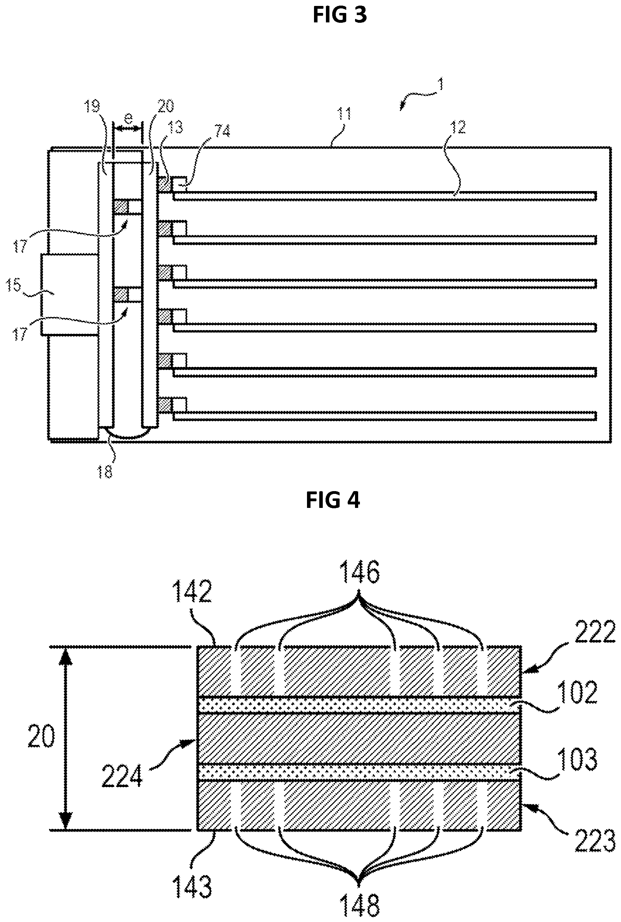

Comme illustré sur la **figure 3****,** il a également été proposé de connecter le connecteur externe 15 à un circuit imprimé de raccordement 19 connecté à la carte électronique de fond de panier 20 par l'intermédiaire d'un circuit imprimé flexible 18 et de connecteurs d'interconnexions complémentaires 17.

Toutes ces solutions sont complexes, coûteuses et encombrantes.

On connait par ailleurs des cartes électroniques, comme celle décrite dans le document US 2005/109532 (D1), comportant deux circuits imprimés collés l'un à l'autre par une couche de résine et présentant une série de premiers trous borgnes débouchant sur la première face de la carte électronique et une série de seconds trous borgnes débouchant sur la seconde face de la carte électronique permettant l'accueil direct de connecteurs utilisant une technologie de broches montées en forces dans des trous métallisés et étant montés directement de part et d'autre de chaque face de PCB.

Or, dans de telles cartes électroniques, la résine risque de remonter dans les trous borgnes lors de l'assemblage des circuits imprimés, ce qui a pour conséquence que les éléments de connexion en forme de broche ne peuvent plus être insérés dans les trous borgnes. Même lorsque les éléments de connexion en forme de broche peuvent être insérés dans les trous borgnes, il existe le risque d'un défaut de contact électrique en raison de la présence de la résine.

En référence à la figure 4, la demande de brevet WO2016151053 décrit une carte électronique de fond de panier 20 présentant une face interne 142 adaptée pour être connectée à des connecteurs de cartes électroniques et une face externe 143 adaptée pour être connectée à un connecteur externe. La carte électronique de fond de panier 20 comprend un premier circuit imprimé 222 présentant une face destinée à former la face interne 142 de la carte électronique de fond de panier 20, un second circuit imprimé 223 présentant une face destinée à former la face externe 143 de la carte électronique de fond de panier 20 et un troisième circuit imprimé 224 entre le premier circuit imprimé 222 et le second circuit imprimé 223.

La carte électronique de fond de panier 20 comprend une première membrane étanche 102, et le premier circuit imprimé 222 présente une série de premiers trous borgnes 146 débouchant d'une part sur la face interne 142 de la carte électronique de fond de panier 20 et d'autre part sur la première membrane étanche 102.

La carte électronique de fond de panier 20 comprend une seconde membrane étanche 103, et le second circuit imprimé 223 présente une série de seconds trous borgnes 148 débouchant d'une part sur la face externe 143 de la carte électronique de fond de panier 20 et d'autre part sur la seconde membrane étanche 103.

Les premiers et les seconds trous borgnes 146, 148 sont adaptés pour recevoir des éléments de connexion à insertion par force et former avec eux un point de connexion électrique. La première membrane étanche 102 est disposée entre le premier circuit imprimé 222 et le troisième circuit imprimé 224 ; la seconde membrane étanche 103 est disposée entre le second circuit imprimé 223 et le troisième circuit imprimé 224. Les premières et secondes membranes étanches empêchent la remontée de la résine utilisée dans le matériau de collage dans les trous borgnes 146, 148 lors de la fabrication de la carte électronique de fond de panier 20.

Toutefois, la présence de ces membranes étanches induit des contraintes supplémentaires de dimensionnement. Une telle carte électronique de fond de panier doit présenter en effet une très faible épaisseur, par exemple entre 3,5 et 6 mm, tandis que les éléments de connexion en forme de broche présentent typiquement une longueur comprise entre 1,7 mm et 2 mm. Ainsi, la présence de ces membranes étanches amène à prévoir au plus juste les dimensions en épaisseurs des éléments de la carte électronique de fond de panier. Toute déviation peut résulter en des trous borgnes pas assez profonds pour accueillir correctement les éléments de connexion en forme de broche. D'autre part, le procédé de fabrication décrit par la demande WO2016151053 prévoit la formation des trous borgnes dans le premier circuit imprimé et le second circuit imprimé après assemblage des trois circuits imprimés, ce qui implique un contrôle strict des perçages. Ces contraintes compliquent la fabrication, augmentent les coûts et les problèmes de non-conformité.

L'état de l'art comprend aussi le document US-A-6090633 et aussi en particulier le document US-A1-2014/353018.

### PRESENTATION DE L'INVENTION

L'invention vise à permettre une fabrication simple et aisée d'une telle carte électronique de fond de panier, qui permette d'éviter une remontée de la résine du matériau de collage dans les trous borgnes, et permette donc d'obtenir des trous borgnes présenter une profondeur utile maximale pour les broches de connexion destinées à être accueillies dans ces trous borgnes.

A cet effet, l'invention propose un procédé de fabrication d'une carte électronique de fond de panier présentant une face interne adaptée pour être connectée à des connecteurs de cartes électroniques et une face externe adaptée pour être connectée à un connecteur externe, une série de premiers trous borgnes débouchant d'une part sur la face interne de la carte électronique de fond de panier et une série de seconds trous borgnes débouchant d'une part sur la face externe de la carte électronique de fond de panier, la carte électronique de fond de panier comprenant :
- un premier circuit imprimé présentant une première face et une seconde face destinée à former la face interne de la carte électronique de fond de panier ;
- un second circuit imprimé présentant une première face et une seconde face destinée à former la face externe de la carte électronique de fond de panier et ;
- un troisième circuit imprimé présentant une première face faisant face à la première face du premier circuit imprimé et une seconde face faisant face à la première face du second circuit imprimé, le troisième circuit imprimé constituant un isolant électrique entre sa première face et sa seconde face lesdits premiers trous borgnes traversant le premier circuit imprimé mais ne traversant pas le troisième circuit imprimé et lesdits seconds trous borgnes traversant le second circuit imprimé mais ne traversant pas le troisième circuit imprimé; le procédé comprenant les étapes suivantes :
   - dépôt sur la première face du troisième circuit imprimé d'une première couche de collage, ladite première couche de collage présentant des premières zones dégagées de matière distribuées sur la première face du troisième circuit imprimé, et dépôt sur la seconde face du troisième circuit imprimé d'une seconde couche de collage, ladite seconde couche de collage présentant des secondes zones dégagées de matière distribuées sur la seconde face du troisième circuit imprimé;
   - assemblage sur la première couche de collage de la première face du premier circuit imprimé, ledit premier circuit imprimé présentant une série de premiers trous traversants destinés à former les premiers trous borgnes, chaque premier trou traversant débouchant dans une première zone dégagée de matière de la première couche de collage sur la première face du troisième circuit imprimé pour former les premiers trous borgnes, et assemblage sur la seconde couche de collage de la première face du second circuit imprimé, ledit second circuit imprimé présentant une série de seconds trous traversants destinés à former les trous borgnes, chaque second trou traversant débouchant dans une seconde zone dégagée de matière pour former les seconds trous borgnes de la seconde couche de collage sur la seconde face du troisième circuit imprimé pour former les seconds trous borgnes.

Afin de former les trous borgnes, les zones dégagées de matière des couches de collage en face de chaque trou des circuits imprimés permet d'éviter la remontée du matériau de collage tel que de la résine dans ces trous borgnes, en absorbant le fluage de cette résine lors de l'assemblage, qui vient combler au moins partiellement ces zones dégagées de matière.

Typiquement, le matériau de collage comprend un tissu imprégné de résine non polymérisée. De préférence, la résine du matériau de collage présente une viscosité dynamique supérieure à 5000 poises entre 80°C et 180°C, et de préférence supérieur à 10000 poises en-dessous de 100°C. L'utilisation d'un tel matériau de collage permet de limiter le fluage du matériau de collage dans les zones dégagées de matière des couches de collage, et permet donc de limiter encore plus le risque de remontée la remontée du matériau de collage tel que de la résine dans les trous borgnes. Par ailleurs, le faible fluage du matériau constituant les couches de collage permet de manipuler ces couches de collage avant le dépôt sur le troisième circuit imprimé, et notamment d'y percer les zones dégagées de matière avant le dépôt.

De préférence, les zones dégagées de matière qui font face aux trous traversants des circuits imprimés destinés à former les trous borgnes présentent un diamètre supérieur aux diamètres de ces trous traversants d'au moins 100 µm, et de préférence d'au moins 250 µm, et de préférence encore d'au moins 500 µm. Le fluage du matériau de la couche de collage lors de l'assemblage vient combler au moins partiellement ces zones dégagées de matière. En raison du diamètre supérieur des zones dégagées de matière, ces zones dégagées de matière présentent une capacité volumique d'absorption plus importante, qui permet donc de mieux absorber le fluage de la résine et donc d'éviter une remontée de la résine dans les trous borgnes. De plus, la résine se trouve initialement plus éloignée des trous traversants des circuits imprimés destinés à former les trous borgnes, ce qui limite encore ce risque.

De préférence, le troisième circuit imprimé comprend des pastilles conductrices distribuées sur ses faces, de sorte que ces pastilles conductrices se trouvent dans des zones dégagées de matière des couches de collage après le dépôt de celles-ci, en face des trous traversants des circuits imprimés destinés à former les trous borgnes. Les pastilles conductrices forment un obstacle au déplacement de la résine lors de l'assemblage en direction des trous traversants des circuits imprimés destinés à former les trous borgnes, et évite donc que la résine ne remonte dans ces trous borgnes. De préférence encore, les pastilles conductrices présentent des évidements centraux face aux trous traversants des circuits imprimés destinés à former les trous borgnes. Les évidements centraux prolongent les trous traversants des circuits imprimés destinés à former les trous borgnes et constituent alors le fond des trous borgnes. Les évidements centraux permettent d'augmenter la profondeur des trous borgnes malgré la présence des pastilles conductrices.

Le procédé est ainsi avantageusement complété par les caractéristiques suivantes, prises seules ou en quelconque de leurs combinaisons techniquement possibles :
- un premier trou traversant présente un diamètre, et une première zone dégagée de matière dans lequel débouche ledit premier trou traversant présente un diamètre supérieur au diamètre du premier trou traversant d'au moins 100 µm; et dans lequel un second trou traversant présente un diamètre, et une seconde zone dégagée de matière dans lequel débouche ledit second trou traversant présente un diamètre supérieur au diamètre du second trou traversant d'au moins 100 µm;
- le matériau de collage comprend un tissu imprégné de résine non polymérisée, et de préférence la résine présente une viscosité dynamique supérieure à 5000 poises entre 80°C et 180°C ;
- la première couche de collage présente les premières zones dégagées de matière avant son dépôt sur la première face du troisième circuit imprimé et/ou la seconde couche de collage présente les secondes zones dégagées de matière avant son dépôt sur la seconde face du troisième circuit imprimé ;
- le troisième circuit imprimé comprend des premières pastilles conductrices distribuées sur la première face, la première couche de collage étant agencée sur la première face du troisième circuit imprimé de sorte que les premières pastilles conductrices se trouvent dans des premières zones dégagées de matière de la première couche de collage, lesdites premières pastilles conductrices font face après assemblage à des premiers trous traversants du premier circuit imprimé pour former le fond des premiers trous borgnes de la face interne de la carte électronique de fond de panier ; et/ou le troisième circuit imprimé comprend des secondes pastilles conductrices distribuées sur la seconde face , la seconde couche de collage étant agencée sur la seconde face du troisième circuit imprimé du troisième circuit imprimé de sorte que les secondes pastilles conductrices se trouvent dans des secondes zones dégagées de matière de la seconde couche de collage, et que les secondes pastilles conductrices font face après assemblage à des seconds trous traversants du second circuit imprimé pour former le fond des seconds trous borgnes de la face externe de la carte électronique de fond de panier ;
- les pastilles conductrices présentent un évidement central en face des trous traversants du premier circuit imprimé et/ou du deuxième circuit imprimé destinés à former les trous borgnes ;
- les pastilles conductrices résultent de la gravure préalable d'une couche conductrice du troisième circuit imprimé ;
- des premiers trous traversants et/ou des seconds trous traversants destinés à former les trous borgnes présentent un revêtement métallique de leurs parois présentant une première collerette s'étendant sur les premières faces des premier et second circuits imprimés ;
- l'assemblage sur la première couche de collage de la première face du premier circuit imprimé comprend une mise en place de la première face du premier circuit imprimé sur la première couche de collage avec les premiers trous traversants destinés à former les trous borgnes face à des premières zones dégagées de matière, et un pressage du premier circuit imprimé sur la première couche de collage avec un chauffage à une température comprise entre 140 et 200°C; et/ou l'assemblage sur la seconde couche de collage de la première face du second circuit imprimé comprend une mise en place de la première face du second circuit imprimé sur la seconde couche de collage avec les seconds trous traversants destinés à former les trous borgnes face à des secondes zones dégagées de matière, et un pressage du second circuit imprimé sur la seconde couche de collage avec un chauffage à une température comprise entre 140 et 200°C.

### PRESENTATION DES FIGURES

L'invention sera mieux comprise, grâce à la description ci-après, qui se rapporte à des modes de réalisations et des variantes selon la présente invention, donnés à titre d'exemples non limitatifs et expliqués avec référence aux dessins schématiques annexés, dans lesquels :
La figure 1 illustre schématiquement un exemple de calculateur électronique de l'état de la technique ;
La figure 2 illustre schématiquement un exemple de calculateur électronique de l'état de la technique ;
La figure 3 illustre schématiquement un exemple de calculateur électronique de l'état de la technique ;
La figure 4 illustre schématiquement une vue en coupe d'une carte électronique de fond de panier de l'état de la technique ;
La figure 5 illustre schématiquement un exemple de calculateur électronique selon un mode de réalisation de l'invention ;
La figure 6 illustre schématiquement un agrandissement des connexions d'une carte électronique de fond de panier selon un mode de réalisation de l'invention ;
La figure 7 illustre schématiquement un agrandissement d'une vue en coupe montrant la composition interne d'une carte électronique de fond de panier selon un mode de réalisation de l'invention ;
La figure 8 illustre schématiquement des étapes de fabrication d'une carte électronique de fond de panier selon un mode de réalisation de l'invention.

### DESCRIPTION DETAILLEE

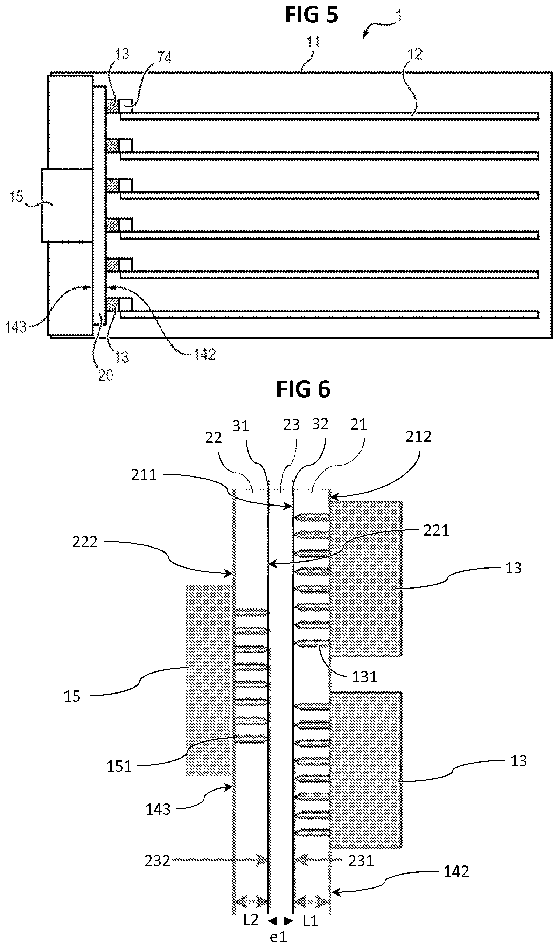

En référence à la **figure 5****,** un calculateur électronique 1 comporte un bâti mécanique 11, une ou plusieurs cartes électroniques 12 maintenues mécaniquement dans le bâti 11 et une carte électronique dite carte de 'fond de panier' 20 ou 'backplane' en anglais qui constitue le fond du bâti mécanique 11.

### Bâti mécanique 11

En référence à la **figure 5****,** le bâti mécanique 11 est typiquement un parallélépipède rectangle comportant deux faces parallèles ouvertes : une première face ouverte adaptée pour l'introduction des cartes électroniques 12 et une deuxième face ouverte adaptée pour être fermée par la carte électronique de fond de panier 20. Les cartes électroniques 12 sont maintenues mécaniquement dans le bâti 11 par exemple par des glissières. La carte électronique de fond de panier 20 est fixée par sa périphérie sur les flancs du bâti mécanique 11. Le calculateur peut également comporter un support de carte électronique de fond de panier fixé au bâti mécanique 11 sur lequel est fixée la carte électronique de fond de panier 20.

### Carte électronique de fond de panier 20

La carte électronique de fond de panier 20 est adaptée pour être fixée sur le bâti mécanique 11 de manière à fermer la deuxième face ouverte du bâti mécanique 11.

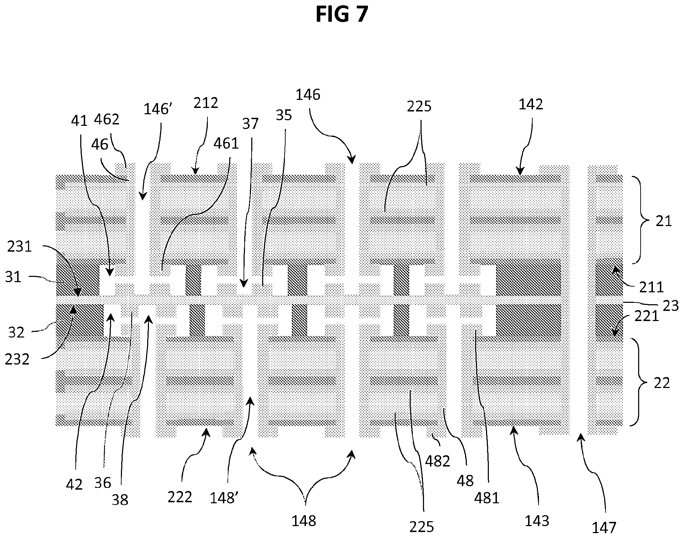

En référence à la **figure 6** et à la **figure 7****,** la carte électronique de fond de panier 20 présente une face interne 142 adaptée pour être connectée à des connecteurs 13 de cartes électroniques 12 et une face externe 143 adaptée pour être connectée à un connecteur externe 15. La carte électronique de fond de panier 20 comprend :
- un premier circuit imprimé 21 présentant une première face 211 et une seconde face 212 destinée à former la face interne 142 de la carte électronique de fond de panier 20 ;
- un second circuit imprimé 22 présentant une première face 221 et une seconde face 222 destinée à former la face externe 143 de la carte électronique de fond de panier 20 et ;
- un troisième circuit imprimé 23 présentant une première face 231 faisant face à la première face 211 du premier circuit imprimé 21 et une seconde face 232 faisant face à la première face 221 du second circuit imprimé 22.

Le premier circuit imprimé 21 et le second circuit imprimé 22 sont des circuits multicouches qui comportent des pistes conductrices 215, 225 à différents niveaux de leur épaisseur pour le routage de signaux entre les différents points de connexion et définissent une zone de routage pour le routage des signaux. Dans la mesure où le premier circuit imprimé 21 et le second circuit imprimé 22 doivent accueillir des éléments de connexion en forme de broche, ils présentent une épaisseur L1, L2 supérieure à 2 à 5 mm. En revanche, le troisième circuit imprimé 23 peut présenter une épaisseur e3 plus faible par rapport au premier circuit imprimé 21 et au second circuit imprimé 22, et par exemple au moins 2 à 3 fois plus faible. Par exemple, le troisième circuit imprimé 23 peut faire entre 50 et 500 µm d'épaisseur, voire moins de 200 µm d'épaisseur.

Les circuits imprimés 21, 22, 23 peuvent être de manière conventionnelle composé de tissus de verre recouvert d'époxy polymérisé, et de pistes conductrices. Toutefois, le troisième circuit imprimé 23 constitue un isolant électrique entre sa première face 231 et sa seconde face 232. De préférence, le circuit imprimé 23 présente un matériau isolant (tel qu'un tissu de verre recouvert d'époxy polymérisé) sur une épaisseur d'au moins 150 µm, et de préférence d'au moins 200 µm, dans la direction entre le premier circuit imprimé 21 et le second circuit imprimé 22.

La carte électronique de fond de panier 20 comprend également une première couche 31 de collage entre la première face 231 du troisième circuit imprimé 23 et la première face 211 du premier circuit imprimé 21. La carte électronique de fond de panier 20 comprend également une seconde couche de collage entre la seconde face du troisième circuit imprimé 23 et la première face du second circuit imprimé 22.

Le troisième circuit imprimé 23 peut comprendre des premières pastilles conductrices 35 distribuées sur la première face 231 du troisième circuit imprimé 23, faisant saillie de cette première face 231, par exemple de 10 µm. Les premières pastilles conductrices 35 font face à des premiers trous traversants 146' du premier circuit imprimé 21 pour former le fond des premiers trous borgnes 146 de la face interne 142 de la carte électronique de fond de panier 20. De même, le troisième circuit imprimé 23 peut comprendre des secondes pastilles conductrices 36 distribuées sur la seconde face 232 du troisième circuit imprimé 23, faisant saillie de cette seconde face 232, par exemple de 10 µm. Les secondes pastilles conductrices 36 font face à des seconds trous traversants 148' du second circuit imprimé 22 pour former le fond des seconds trous borgnes 148 de la face externe 143 de la carte électronique de fond de panier 20. Typiquement, les pastilles conductrices 35, 36 sont en cuivre. Les pastilles conductrices 35, 36 présentent par exemple une épaisseur de 20 µm à 40 µm. Les pastilles conductrices 35, 36 sont typiquement de forme circulaire ou annulaire.

De préférence les pastilles conductrices 35, 36 présentent des évidements centraux 37, 38 face aux trous traversants 146', 148" des circuits imprimés 21, 22 destinés à former les trous borgnes 146, 148. Les évidements centraux 37, 38 prolongent les trous traversants 146', 148" des circuits imprimés 21, 22 destinés à former les trous borgnes 146, 148 et constituent alors le fond des trous borgnes 146, 148. Les évidements centraux 37, 38 permettent d'augmenter la profondeur des trous borgnes 146, 148 malgré la présence des pastilles conductrices 35, 36. Les évidements centraux 37, 38 peuvent être réalisés par perçage des pastilles conductrices 35, 36, ou peuvent être réalisés lors d'une étape de gravure du troisième circuit imprimé 23 permettant de former les pastilles conductrices 35, 36. Les évidements centraux 37, 38 peuvent s'étendre sur toute la profondeur des pastilles conductrices 35, 36, comme illustré sur la **figure 7****,** ou bien ne s'étendre que sur une partie de la profondeur des pastilles conductrices 35, 36. Par exemple, les évidements centraux 37, 38 s'étendent sur une profondeur de 17 à 35 µm.

### Carte électronique 12

Chaque carte électronique 12 comprend un circuit imprimé et des composants électroniques. Chaque carte électronique 12 est connectée au moyen d'un ou de plusieurs connecteurs de carte 13 sur la face interne 142 de la carte électronique de fond de panier 20. Les connecteurs de carte 13 présentent des éléments de connexion à insertion par force 131 **(****figure 6****)** qui sont typiquement des éléments de connexion en forme de broche. Ces éléments de connexion en forme de broche ont typiquement une longueur 12 comprise entre 1 et 2,5 mm.

### Connecteur externe de type ARINC 600 15

Un ou plusieurs modules de pilotage sont connectés à la carte électronique de fond de panier 20 de manière à communiquer avec le bus de celle-ci selon un protocole de bus série distribués par exemple de types ARINC 429. Chaque module de pilotage est constitué d'une ou plusieurs cartes adaptées pour être connectée sur la face externe 143 de la carte électronique de fond de panier 20 par un connecteur externe 15 par exemple un connecteur de type ARINC 600. Le connecteur externe 15 comporte une emprise comportant des empreintes de connecteur présentant des éléments de connexion à insertion par force 151 **(****figure 6****)** qui sont typiquement des éléments de connexion en forme de broche. Ces éléments de connexion en forme de broche 151 ont typiquement une longueur 11 comprise entre 1 et 2,5 mm.

### Trous borgnes

En référence à la **figure 7****,** la carte électronique de fond de panier 20 possède des premiers trous borgnes 146 débouchant sur sa face interne 142 et adaptés pour recevoir des éléments de connexion à insertion par force portés par les connecteurs de carte 13, et des seconds trous borgnes 148 débouchant sur sa face externe 143 et adaptés pour recevoir des éléments de connexion à insertion par force portés par les connecteurs externe 15. Les trous borgnes 146, 148 ne traversent pas la carte électronique de fond de panier 20 de part et d'autre. Plus précisément, les premiers trous borgnes 146 traversent le premier circuit imprimé 21, mais ne traversent ni le troisième circuit imprimé 23 ni le second circuit imprimé 22. De même, les seconds trous borgnes 148 traversent le second circuit imprimé 22, mais ne traversent ni le troisième circuit imprimé 23 ni le premier circuit imprimé 21. Les trous borgnes 146, 148 sont coaxiaux et perpendiculaires au plan de la carte électronique de fond de panier 20.

Les trous borgnes 146,148 sont principalement constitués par des trous traversants 146', 148' ménagés dans le premier et le second circuit imprimé 21, 22. Le troisième circuit imprimé 23 ferme les trous borgnes 146, 148, et permet, par l'isolation électrique qu'il procure, de garantir la tenue diélectrique entre le premier et le second circuit imprimé 21, 22, même au niveau des trous borgnes 146, 148.

Les trous traversants 146', 148' sont métallisés et présentent donc des revêtements métalliques 46, 48 sur leurs parois. Ces revêtements métalliques 46, 48 permettent d'établir une liaison électrique entre les différentes couches conductrice d'un même circuit imprimé multicouche 21, 22. La métallisation des trous consiste à déposer une fine couche de cuivre à l'intérieur du trou, par un procédé de dépôt de cuivre par électrolyse. Une fois métallisé, le trou fait la connexion électrique entre les couches qu'il traverse. Les revêtements métalliques 46, 48 des parois des trous traversants 146', 148' présentent de préférence chacun une première collerette 461, 481 s'étendant sur les premières faces 211, 221 des circuits imprimés 21, 22. Les revêtements métalliques 46, 48 des parois des trous traversants 146', 148' peuvent également chacun présenter une seconde collerette 462, 482 s'étendant sur les secondes faces 212, 222 des circuits imprimés 21, 22.

### Trous métallisés traversants

La carte électronique de fond de panier 20 possède des trous traversants 147 qui traversent la carte électronique de fond de panier 20 de part et d'autre. Plus précisément, les trous traversants 147 traversent le premier circuit imprimé 21, le troisième circuit imprimé 23 et le second circuit imprimé 24. Les trous traversants 147 sont métallisés et permettent d'établir une connexion électrique entre l'ensemble des couches conductrices 215, 225. Les trous traversants 147 sont coaxiaux et perpendiculaires au plan de la carte électronique de fond de panier 20. La paroi métallique du trou traversant métallisé 147 et des couches conductrices reliées à deux équipotentiels forment ensemble un réseau filtrant passe-bas assurant une fonction de filtrage du bruit électromagnétique.

### Eléments de connexion à insertion par force

Les éléments de connexion à insertion par force 131 portés par les connecteurs de carte 13 et les éléments de connexion à insertion par force 151 portés par le connecteur externe 15 sont adaptés pour être insérés à force dans un des trous borgnes 146, 148 de la carte électronique de fond de panier 20 de manière à former une jonction électrique à insertion par force dite 'press-fit, assurant l'interconnexion mécanique et électrique. Une fois l'élément de connexion à insertion par force 131 ou 151 inséré dans un trou borgne 146, 148, ils constituent ensemble un point de connexion.

Lorsqu'un élément de contact en forme de broches 131 et 151 est enfoncé dans un trou borgne 146 ou 148, l'élément de contact en forme de broche 131 et 151 et/ou les trous borgnes 146, 148 se déforment de manière élastique lors de l'insertion, de manière à créer une force de friction entre les deux. A cet effet, les éléments de contact en forme de broche 131, 151 présentent des propriétés d'élasticité en compression. Les broches comprennent une partie d'ajustement par pression adaptée pour être mis en contact avec une surface interne des trous borgnes 146, 148 du circuit imprimé. La partie d'ajustement par pression comprend un mécanisme à ajustement serré adapté pour être déformé élastiquement lors de l'insertion dans les trous borgnes 146, 148. Ce mécanisme à ajustement serré comprend typiquement une saillie et un évidement complémentaire comme par exemple un bossage ou une fente en forme de 'chat d'aiguille' au centre de l'axe longitudinal de la broche.

Alternativement ou en complément les trous borgnes 146, 148 présentent des propriétés d'élasticité. Le diamètre des trous borgnes 146, 148 est légèrement plus petit que la largeur de la broche, de manière à ce que l'insertion crée une force de frottement. Les trous borgnes 146, 148 ont typiquement une forme cylindrique.

Pour améliorer l'insertion et le maintien des broches dans les trous borgnes 146, 148, les trous borgnes 146, 148 présentent avantageusement un diamètre diminuant dans une direction orientée de l'intérieur de la carte électronique à la surface de la carte électronique. Les trous borgnes 146, 148 ont par exemple une forme tronconique.

### Procédé de fabrication

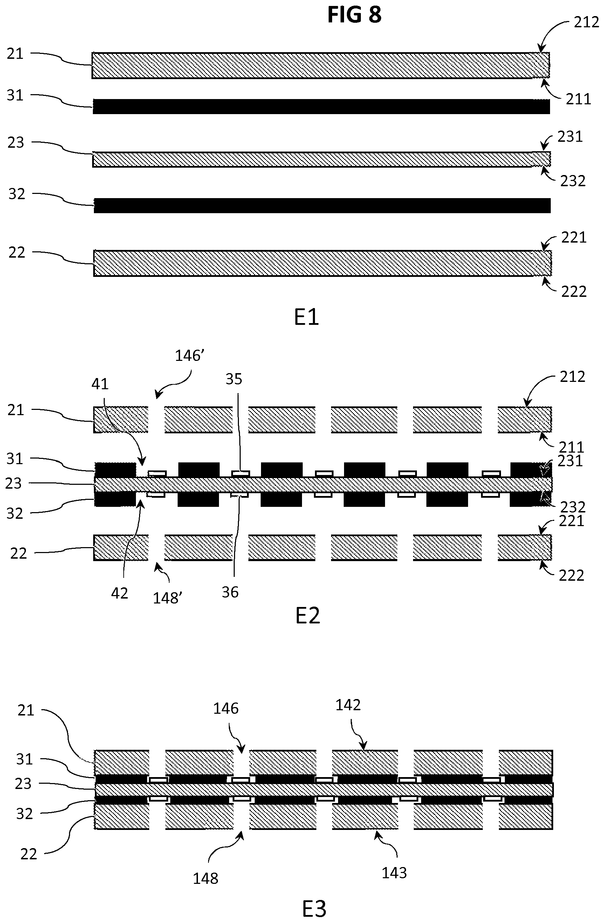

En référence à la **figure 8****,** la carte électronique de fond de panier 20 peut être fabriquée selon un procédé comportant les étapes suivantes. L'ordre des étapes est indicatif et peut être modifié. Il est par exemple possible de réaliser les trous 146', 148' traversant les circuits imprimés 21, 22 avant ou après la réalisation des zones dégagées 41, 42 des couches 31, 32 de collage, et après ou avant le dépôt de ces couches 31, 32 de collage sur le troisième circuit imprimé 23.

Dans une première étape El sont fournis le premier circuit imprimé 21 présentant une première face 211 et une seconde face 212 destinée à former la face interne 142 de la carte électronique de fond de panier 20, un second circuit imprimé 22 présentant une première face 221 et une seconde face 222 destinée à former la face externe 143 de la carte électronique de fond de panier 20 et un troisième circuit imprimé 23 présentant une première face 231 et une seconde face 232.

Sont également fournis une première couche 31 de collage et une seconde couche 32 de collage. Une couche de collage 31, 32 est constitué de matériau de collage, lequel comprend un support tel qu'un tissu, généralement de verre, imprégné d'une résine non polymérisée, matériau couramment désigné sous le terme anglais de "pre-preg". La résine est typiquement de type époxy, mais peut également être composée d'autre matériau tel que du poly(oxyde de phénylène) (PPO) ou du polyphénylène éther (PPE). Le taux de résine non polymérisée dans le matériau de collage est par exemple compris entre 60 et 80%.

Dans tous les cas, la résine présente une haute viscosité dynamique et donc un faible fluage. Une telle résine est couramment qualifiée par les termes anglais de "no-flow" ou "low-flow". Ainsi, la résine présente de préférence une viscosité dynamique supérieure à 5000 poises entre 80°C et 180°C, et de préférence supérieur à 10000 poises en-dessous de 100°C. Une résine "no-flow" ou "low-flow" se distingue donc des résines dites "uniflow" ou "standard flow", qui présentent généralement des viscosités dynamiques dix fois moindres.

La viscosité dynamique peut par exemple être mesurée avec une température croissant de 3 à 8°C par minutes pour atteindre la température à tester. Cette faible viscosité permet d'éviter la remontée de résine par fluage lors de l'assemblage de la carte électronique de fond de panier 20, mais permet également de réaliser des zones dégagées de matière dans les couches de collage 31, 32 avant même leur dépôt sur un circuit imprimé, ce qui facilite la réalisation de ces zones dégagées de matière. De fait, une couche de collage 31, 32 afin son dépôt se présente sous la forme d'une feuille.

Dans une étape El', il est donc possible de réaliser dans la première couche 31 de collage des premières zones 41 dégagées de matière, et dans la seconde couche 32 de collage des secondes zones 42 dégagées de matière. Les zones 41, 42 dégagées de matière sont positionnées de sorte à ce que leurs emplacements correspondent aux emplacements destinés aux trous borgnes 146, 148. Les zones 41, 42 dégagées de matière sont dépourvues de la matière constituant les couches de collage 31, 32, et forment donc des trous traversants dans ces couches de collage 31, 32. Les zones 41, 42 dégagées de matière peuvent être réalisés par perçage avec un foret ou un laser, ou par matriçage.

Dans une étape El", une série de premiers trous traversants 146' sont réalisés dans le premier circuit imprimé 21. Les premiers trous traversants 146' s'étendent de la première face 211 du premier circuit imprimé 21 à la seconde face 212 du premier circuit imprimé 21. De même, une série de seconds trous traversants 148' sont réalisés dans le second circuit imprimé 22. Les seconds trous traversants 148' s'étendent de la première face 221 du second circuit imprimé 22 à la seconde face 222 du second circuit imprimé 22. Des premiers trous traversants 146' et/ou des seconds trous traversants 148' présente un revêtement métallique 46, 48 de leurs parois. Les revêtements métalliques 46, 48 des parois des trous traversants 146', 148' présentent de préférence chacun une première collerette 461, 481 s'étendant sur les premières faces 211, 221 des circuits imprimés 21, 22. Ces premières collerettes 461, 481 forment un obstacle au fluage du matériau de collage des couches de collage 31, 32. Les revêtements métalliques 46, 48 des parois des trous traversants 146', 148' peuvent également chacun présenter une seconde collerette 462, 482 s'étendant sur les secondes faces 212, 222 des circuits imprimés 21, 22. Les collerettes 461, 481, 462, 482 peuvent par exemple être obtenu par gravure de couches conductrices des circuits imprimés 21, 22.

Dans une étape E1‴, si les pastilles conductrices 35, 36 sont prévues, celles-ci peuvent être réalisées par une gravure préalable d'une couche conductrice du troisième circuit imprimé 23. A cet effet, le troisième circuit imprimé 23 peut être initialement un circuit imprimé double face, et les zones cuivrées des couches conductrices sont conservées lors de la gravure pour former les pastilles conductrices 35, 36. Comme indiqué plus haut, les pastilles conductrices 35, 36 peuvent présenter des évidements centraux 37, 38 destinés à faire face aux trous traversants 146', 148' des circuits imprimés 21, 22 destinés à former les trous borgnes 146, 148.

Dans une étape E2, la première couche de collage 31 est déposée sur la première face 231 du troisième circuit imprimé 23, et dépôt sur la seconde face 232 du troisième circuit imprimé 23 de la seconde couche de collage 32. La première couche de collage 31 est agencée sur la première face 231 du troisième circuit imprimé 23 de sorte que les premières pastilles conductrices 35 se trouvent dans des premières zones 41 dégagées de matière de la première couche de collage 31. De même, la seconde couche de collage 32 est agencée sur la seconde face 232 du troisième circuit imprimé 23 de sorte que les secondes pastilles conductrices 36 se trouvent dans des secondes zones 42 dégagées de matière de la seconde couche de collage 32. Les premières collerettes 461, 481 des revêtements métalliques 46, 48 se trouvent également dans les zones dégagées de matière 41, 42 des couches de collage 31, 32.

Dans une étape E3, la première face 211 du premier circuit imprimé 21 est apposée sur la première couche de collage 31. Lors de l'assemblage, chaque premier trou traversant 146' du premier circuit imprimé 21 est aligné avec une première zone dégagée de matière 41 de la première couche de collage 31. Ainsi, le premier circuit imprimé 21 est agencé de sorte que chaque premier trou traversant 146' du premier circuit imprimé 21 débouche dans une première zone dégagée 41 de matière pour former les premiers trous borgnes 146. De même, la première face 221 du second circuit imprimé 22 est apposée sur la seconde couche de collage 32. Lors de l'assemblage, chaque second trou traversant 148' du second circuit imprimé 22 est aligné avec une seconde zone dégagée de matière 42 de la seconde couche de collage 32. Ainsi, le second circuit imprimé 22 est agencé de sorte que chaque second trou traversant 148' du second circuit imprimé 22 débouche dans une seconde zone 42 dégagée de matière pour former les seconds trous borgnes 148. De préférence, les trous traversants 146', 148' et les zones 41, 42 dégagées de matière sont de section circulaire, et sont alignés de manière sensiblement coaxiale lors de l'assemblage des circuits imprimés 21, 22, 23.

Il est à noter que la première zone 41 dégagée de matière dans lequel débouche un premier trou traversant 146' présente un diamètre supérieur au diamètre du premier trou traversant 146' d'au moins 100 µm, et de préférence d'au moins 250 µm, et de préférence encore d'au moins 500 µm. De même, une seconde zone 42 dégagée de matière dans lequel débouche un second trou traversant 148' présente un diamètre supérieur au diamètre du second trou traversant 148' d'au moins 100 µm, et de préférence d'au moins 250 µm, et de préférence encore d'au moins 500 µm. En présence d'une première collerette 461, 481, les zones dégagées de matière 41, 42 présentent un diamètre supérieur à celui de la première collerette 461,481, de préférence d'au moins 100 µm, de préférence encore d'au moins 250 µm, et de préférence encore d'au moins 500 µm. De plus, les zones dégagées de matière 41, 42 et les trous traversants 146', 148' présentent de préférence des centres alignés, de sorte que les zones dégagées de matière 41, 42 s'étendent de part et d'autre du prolongement des trous traversants 146', 148' dans le plan des couches de collage 31, 32.

Une fois que le premier circuit imprimé 21 a été mis en place sur la première couche de collage 31 et que le second circuit imprimé 22 a été mis en place sur la seconde couche de collage 32, le procédé comprend ensuite un pressage du premier circuit imprimé 21 sur la première couche de collage 31 et un pressage du second circuit imprimé 22 sur la seconde couche de collage 32. Ce pressage peut être accompagné d'une réduction de la pression de l'air ambiant par vide d'air. Lors du pressage, les pastilles conductrices35, 36 peuvent venir au contact du revêtement métallique des parois des trous traversants 146', 148".

Lors de l'assemblage, et en particulier lors de l'étape de pressage de l'assemblage, la résine des couches de collage 31, 32 flue dans le plan d'interface des couches de collage 31, 32, et vient combler au moins partiellement les zones 41, 42 dégagées de matière de ces couches de collage 31, 32. La présence des zones 41, 42 dégagées de matière permet d'absorber le fluage de la résine, et d'éviter la remontée de résine dans les trous traversants 146', 148' des circuits imprimés 21, 22. Le choix d'une résine à haute viscosité pour les couches de collage 31, 32 permet de limiter ce fluage, et donc d'éviter encore mieux cette remontée de résine. Par ailleurs, les zones 41, 42 dégagées de matière permettent d'autant mieux d'éviter la remontée de résine que leur diamètre est supérieur au diamètre des trous traversants 146', 148' des circuits imprimés 21, 22.

La présence de pastilles conductrices 35, 36 permet de faire obstacle au fluage du matériau de collage des couches de collage 31, 32, tel que la résine. La résine est alors arrêtée contre les pastilles conductrices 35, 36 qui font face aux trous traversants 146', 148' des circuits imprimés 21, 22, et ne remonte pas dans ceux-ci. Les pastilles conductrices 35, 36 permettent au moins de ralentir le fluage du matériau de collage des couches de collage 31, 32. De même, les premières collerettes 461, 481 permettent de faire obstacle au fluage du matériau de collage des couches de collage 31, 32, tel que la résine. Cet effet est d'autant plus accentué lorsque les pastilles conductrices 35, 36 viennent au contact des premières collerettes 461, 481 des revêtements métalliques 46, 48 des parois des premiers trous traversants 146' et/ou des seconds trous traversants 148' destinés à former les trous borgnes 146, 148. La forme des pastilles conductrices 35, 36 est choisie afin de faciliter au mieux cet arrêt ou cette limitation du fluage de la résine. Les pastilles conductrices 35, 36 peuvent ainsi non seulement être en forme de disque ou d'anneaux concentriques, ou tout autre forme appropriée.

Les premiers trous traversant 146' du premier circuit imprimé 21, éventuellement prolongés par le restant des premières zones 31 dégagées de matière après le fluage de la résine, forment les premiers trous borgnes 146 de la carte électronique de fond de panier 20, tandis que les seconds trous traversant 148' du second circuit imprimé 22, éventuellement prolongés par le restant des secondes zones 32 dégagées de matière après le fluage de la résine, forment les seconds trous borgnes 148 de la carte électronique de fond de panier 20.

Enfin, la résine des couches de collage 31, 32 est polymérisée afin de finaliser l'assemblage. Typiquement, afin de permettre la polymérisation de la résine des couches de collage 31, 32, le pressage est maintenu pendant le temps nécessaire, par exemple de une à plusieurs heures, de préférence avec un chauffage à une température comprise entre 120°C et 200°C, et de préférence entre 150°C et 180°C. Cette température est généralement atteinte via une montée en température contrôlée, par exemple entre 3 et 8°C par minutes, et est maintenue pendant plusieurs dizaines de minutes, tandis qu'est maintenu le pressage. Une fois polymérisée, la résine de la couche de collage présente des propriétés diélectriques similaires au matériau isolant des circuits imprimés 21, 22, 23.

Après l'assemblage, la seconde face 212 du premier circuit imprimé 21 forme la face interne 142 de la carte électronique de fond de panier (20), et la seconde face 222 du second circuit imprimé 22 forme la face externe 143 de la carte électronique de fond de panier 20.

Une fois l'assemblage effectué, il est possible de réaliser par perçage les trous traversants 147 de la carte électronique de fond de panier, traversant le premier circuit imprimé 21, la première couche de collage 31, le troisième circuit imprimé 23, la seconde couche de collage 32, et le second circuit imprimé 22. Ces trous traversants 147 sont ensuite métallisés, afin de permettre une connexion électrique entre le premier circuit imprimé 21 et le second circuit imprimé 22.

Pour garantir la propreté des trous borgnes 146, 148 lors de la réalisation des trous traversants 147, il est possible de disposer un film de fermeture en plastique fermant les trous borgnes 146, 148. Ainsi, un film de fermeture peut être disposé à la surface de la seconde face 212 du premier circuit imprimé 21, ou sur la seconde face 222. Afin de permettre une introduction ultérieure d'un élément de contact en forme de broches 131, 151 dans les trous borgnes 146, 148, il est possible de prévoir des micro-fentes dans le film de fermeture au niveau d'embouchures de trous borgnes 146, 148. Ces micro-fentes peuvent avantageusement être réalisées par laser, et plus particulièrement au moyen d'un robot laser capable de réaliser de telles découpes qui sont utilisées pour d'autres applications lors de la fabrication de circuits imprimés. Les micro-fentes du film de fermeture permettent de continuer à assurer la protection des trous borgnes 146, 148 tout en permettant, lors de l'introduction d'éléments de contact dans des trous borgnes 146, 148, un percement net et sans impact sur la qualité ultérieure des connexions entre les éléments de contact et le premier et second circuits imprimés 21, 22.

L'invention n'est pas limitée au mode de réalisation décrit et représenté aux figures annexées. Des modifications restent possibles, notamment du point de vue de la constitution des divers caractéristiques techniques , sans sortir pour autant du domaine de protection de l'invention.

## Revendications

1. Procédé de fabrication d'une carte électronique de fond de panier (20) présentant une face interne (142) adaptée pour être connectée à des connecteurs (13) de cartes électroniques (12) et une face externe (143) adaptée pour être connectée à un connecteur externe (15), une série de premiers trous borgnes (146) débouchant d'une part sur la face interne (142) de la carte électronique de fond de panier (20) et une série de seconds trous borgnes (148) débouchant d'une part sur la face externe (143) de la carte électronique de fond de panier (20), la carte électronique de fond de panier (20) comprenant :
- un premier circuit imprimé (21) présentant une première face et une seconde face destinée à former la face interne (142) de la carte électronique de fond de panier (20) ;
- un second circuit imprimé (22) présentant une première face et une seconde face destinée à former la face externe (143) de la carte électronique de fond de panier (20) et ;
- un troisième circuit imprimé (23) présentant une première face (231) faisant face à la première face du premier circuit imprimé (21) et une seconde face (232) faisant face à la première face du second circuit imprimé (22), le troisième circuit imprimé (23) constituant un isolant électrique entre sa première face (231) et sa seconde face (232);
lesdits premiers trous borgnes (146) traversant le premier circuit imprimé (21) mais ne traversant pas le troisième circuit imprimé (23) et lesdits seconds trous borgnes (148) traversant le second circuit imprimé (22) mais ne traversant pas le troisième circuit imprimé (23) ;
**caractérisé en ce que** le procédé comprend les étapes suivantes :
- dépôt sur la première face du troisième circuit imprimé (23) d'une première couche de collage (31), ladite première couche de collage (31) présentant des premières zones(41) dégagées de matière distribuées sur la première face (231) du troisième circuit imprimé (23), et dépôt d'une seconde couche de collage (32) sur la seconde face (232) du troisième circuit imprimé (23), ladite seconde couche de collage (32) présentant des secondes zones (42) dégagées de matière distribuées sur la seconde face (232) du troisième circuit imprimé (23);
- assemblage sur la première couche de collage de la première face du premier circuit imprimé (21), ledit premier circuit imprimé (21) présentant une série de premiers trous traversants (146') destinés à former les premiers trous borgnes (146), chaque premier trou traversant (146') débouchant dans une première zone dégagée de matière de la première couche de collage (31) sur la première face (231) du troisième circuit imprimé (23) pour former les premiers trous borgnes (146), et assemblage sur la seconde couche de collage de la première face du second circuit imprimé (22), ledit second circuit imprimé (22) présentant une série de seconds trous traversants (148') destinés à former les seconds trous borgnes (148), chaque second trou traversant (148') débouchant dans une seconde zone (42) dégagée de matière de la seconde couche de collage (32) sur la seconde face (232) du troisième circuit imprimé (23) pour former les seconds trous borgnes (148).

2. Procédé selon la revendication 1, dans lequel un premier trou traversant (146') présente un diamètre, et une première zone dégagée de matière dans lequel débouche ledit premier trou traversant (146') présente un diamètre supérieur au diamètre du premier trou traversant (146') d'au moins 100 µm; et dans lequel un second trou traversant (148') présente un diamètre, et une seconde zone dégagée de matière dans lequel débouche ledit second trou traversant (148') présente un diamètre supérieur au diamètre du second trou traversant (148') d'au moins 100 µm.

3. Procédé selon l'une quelconque des revendications précédentes, dans lequel le matériau de collage comprend un tissu imprégné de résine non polymérisée.

4. Procédé selon la revendication 3, dans lequel la résine présente une viscosité dynamique supérieure à 5000 poises entre 80°C et 180°C.

5. Procédé selon l'une quelconque des revendications précédentes, dans lequel la première couche de collage (31) présente les premières zones (41) dégagées de matière avant son dépôt sur la première face (231) du troisième circuit imprimé (23) et/ou la seconde couche de collage (32) présente les secondes zones (42) dégagées de matière avant son dépôt sur la seconde face (232) du troisième circuit imprimé (23).

6. Procédé selon l'une quelconque des revendications précédentes, dans lequel le troisième circuit imprimé (23) comprend des premières pastilles conductrices (35) distribuées sur la première face, la première couche de collage (31) étant agencée sur la première face (231) du troisième circuit imprimé (23) de sorte que les premières pastilles conductrices (35) se trouvent dans des premières zones (41) dégagées de matière de la première couche de collage (31), et que lesdites premières pastilles conductrices (35) font face après assemblage à des premiers trous traversants (146') du premier circuit imprimé (21) pour former le fond des premiers trous borgnes (146) de la face interne (142) de la carte électronique de fond de panier (20); et/ou le troisième circuit imprimé (23) comprend des secondes pastilles conductrices (36) distribuées sur la seconde face (232) , la seconde couche de collage étant agencée sur la seconde face du troisième circuit imprimé (23) du troisième circuit imprimé (23) de sorte que les secondes pastilles conductrices (36) se trouvent dans des secondes zones (42) dégagées de matière de la seconde couche de collage (32), et que les secondes pastilles conductrices (36) font face après assemblage à des seconds trous traversants (148') du second circuit imprimé (22) pour former le fond des seconds trous borgnes (148) de la face externe (143) de la carte électronique de fond de panier (20).

7. Procédé selon la revendication 6, dans lequel les pastilles conductrices (35, 36) présentent un évidement central (37, 38) en face des trous traversants (146', 148") du premier circuit imprimé (21) et/ou du deuxième circuit imprimé (22) destinés à former les trous borgnes (146, 148).

8. Procédé selon l'une des revendications 6 ou 7, dans lequel les pastilles conductrices (35, 36) résultent de la gravure préalable d'une couche conductrice du troisième circuit imprimé (23).

9. Procédé selon l'une quelconque des revendications précédentes, dans lequel des premiers trous traversants (146') et/ou des seconds trous traversants (148') destinés à former les trous borgnes (146, 148) présentent un revêtement métallique (46, 48) de leurs parois présentant une première collerette (461, 481) s'étendant sur les premières faces (211, 221) des premier et second circuits imprimés (21, 22).

10. Procédé selon l'une quelconque des revendications précédentes, dans lequel l'assemblage sur la première couche de collage (31) de la première face (211) du premier circuit imprimé (21) comprend une mise en place de la première face du premier circuit imprimé (21) sur la première couche de collage (31) avec les premiers trous traversants (146') destinés à former les trous borgnes (146, 148) face à des premières zones (41) dégagées de matière, et un pressage du premier circuit imprimé (21) sur la première couche de collage (31) avec un chauffage à une température comprise entre 140 et 200°C; et/ou l'assemblage sur la seconde couche de collage (32) de la première face (221) du second circuit imprimé (22) comprend une mise en place de la première face (221) du second circuit imprimé (22) sur la seconde couche de collage (32) avec les seconds trous traversants (148') destinés à former les trous borgnes (146, 148) face à des secondes zones (42) dégagées de matière, et un pressage du second circuit imprimé (22) sur la seconde couche de collage (32) avec un chauffage à une température comprise entre 140 et 200°C.

## Patentansprüche

1. Verfahren zur Herstellung einer elektronischen Rückenplatine (20), die eine innere Fläche (142) aufweist, die zur Verbindung mit Verbindern (13) elektronischer Karten (12) geeignet ist, und eine äußere Fläche (143), die zur Verbindung mit einem äußeren Verbinder (15) geeignet ist, wobei eine Reihe erster Sacklöcher (146) zum einen auf der inneren Fläche (142) der elektronischen Rückenplatine (20) ausmünden, und eine Reihe zweiter Sacklöcher (148) zum einen auf der äußeren Fläche (143) der elektronischen Rückenplatine (20) ausmünden, wobei die elektronische Rückenplatine (20) umfasst:
- eine erste Leiterplatte (21), die eine erste Fläche und eine zweite Fläche aufweist, die bestimmt ist, die innere Fläche (142) der elektronischen Rückenplatine (20) zu bilden;
- eine zweite Leiterplatte (22), die eine erste Fläche und eine zweite Fläche aufweist, die bestimmt ist, die äußere Fläche (143) der elektronischen Rückenplatine (20) zu bilden; und
- eine dritte Leiterplatte (23), die eine erste Fläche (231) aufweist, die der ersten Fläche der erste Leiterplatte (21) gegenüberliegt, und eine zweite Fläche (232), die der ersten Fläche der zweite Leiterplatte (22) gegenüberliegt, wobei die dritte Leiterplatte (23) eine elektrische Isolation zwischen seiner ersten Fläche (231) und seiner zweiten Fläche (232) bildet;
wobei die ersten Sacklöcher (146) die erste Leiterplatte (21) durchqueren, aber nicht die dritte Leiterplatte (23) durchqueren und die zweiten Sacklöcher (148) die zweite Leiterplatte (22) durchqueren, aber nicht die dritte Leiterplatte (23) durchqueren;
**dadurch gekennzeichnet, dass** das Verfahren die folgenden Schritte umfasst:
- Aufbringen, auf die erste Fläche der dritte Leiterplatte (23), einer ersten Kleberschicht (31), wobei die erste Kleberschicht (31) erste materialbefreite Zonen (41) aufweist, die auf der ersten Fläche (231) der dritte Leiterplatte (23) verteilt sind, und Aufbringen einer zweiten Kleberschicht (32) auf die zweite Fläche (232) der dritte Leiterplatte (23), wobei die zweite Kleberschicht (32) zweite materialbefreite Zonen (42) aufweist, die auf der zweiten Fläche (232) der dritte Leiterplatte (23) verteilt sind;
- Anordnen, auf der ersten Kleberschicht, der ersten Fläche der erste Leiterplatte (21), wobei die erste Leiterplatte (21) eine Reihe erster Durchgangslöcher (146') aufweist, die bestimmt sind, die ersten Sacklöcher (146) zu bilden, wobei jedes erste Durchgangsloch (146') in einer ersten materialfreien Zone der ersten Kleberschicht (31) auf der ersten Fläche (231) der dritte Leiterplatte (23) ausmündet, um die ersten Sacklöcher (146) zu bilden, und Anordnen, auf der zweiten Kleberschicht, der ersten Fläche der zweite Leiterplatte (22), wobei die zweite Leiterplatte (22) eine Reihe zweiter Durchgangslöcher (148') aufweist, die bestimmt sind, die zweiten Sacklöcher (148) zu bilden, wobei jedes zweite Durchgangsloch (148') in einer zweiten materialfreien Zone (42) der zweiten Kleberschicht (32) auf der zweiten Fläche (232) der dritte Leiterplatte (23) ausmündet, um die zweiten Sacklöcher (148) zu bilden.

2. Verfahren nach Anspruch 1, wobei ein erstes Durchgangsloch (146') einen Durchmesser aufweist, und eine erste materialfreie Zone, in die das erste Durchgangsloch (146') ausmündet, einen Durchmesser aufweist, der um mindestens 100 µm größer als der Durchmesser des ersten Durchgangslochs (146') ist; und wobei ein zweites Durchgangsloch (148') einen Durchmesser aufweist, und eine zweite materialfreie Zone, in die das zweite Durchgangsloch (148') ausmündet, einen Durchmesser aufweist, der um mindestens 100 µm größer als der Durchmesser des zweiten Durchgangslochs (148') ist.

3. Verfahren nach einem der vorangehenden Ansprüche, wobei das Klebermaterial einen mit nicht polymerisiertem Harz imprägnierten Stoff umfasst.

4. Verfahren nach Anspruch 3, wobei das Harz zwischen 80°C und 180°C eine dynamische Viskosität über 5000 Poise aufweist.

5. Verfahren nach einem der vorangehenden Ansprüche, wobei die erste Kleberschicht (31) die ersten materialfreien Zonen (41) vor ihrem Aufbringen auf die erste Fläche (231) der dritte Leiterplatte (23) aufweist und/oder die zweite Kleberschicht (32) die zweiten materialfreien Zonen (42) vor ihrem Aufbringen auf die zweite Fläche (232) der dritte Leiterplatte (23) aufweist.

6. Verfahren nach einem der vorangehenden Ansprüche, wobei die dritte Leiterplatte (23) erste leitende Pads (35) umfasst, die auf der ersten Fläche verteilt sind, wobei die erste Kleberschicht (31) auf der ersten Fläche (231) der dritte Leiterplatte (23) derart eingerichtet ist, dass sich die ersten leitenden Pads (35) in den ersten materialfreien Zonen (41) der ersten Kleberschicht (31) befinden, und dass die ersten leitenden Pads (35) nach Anordnung den ersten Durchgangslöchern (146') der erste Leiterplatte (21) gegenüberliegen, um den Rücken der ersten Sacklöcher (146) der inneren Fläche (142) der elektronischen Rückenplatine (20) zu bilden; und/oder die dritte Leiterplatte (23) zweite leitende Pads (36) umfasst, die auf der zweiten Fläche (232) verteilt sind, wobei die zweite Kleberschicht auf der zweiten Fläche der dritte Leiterplatte (23) derart eingerichtet ist, dass sich die zweiten leitenden Pads (36) in zweiten materialfreien Zonen (42) der zweiten Kleberschicht (32) befinden, und dass die zweiten leitenden Pads (36) nach Anordnung den zweiten Durchgangslöchern (148') der zweite Leiterplatte (22) gegenüberliegen, um den Rücken der zweiten Sacklöcher (148) der äußeren Fläche (143) der elektronischen Rückenplatine (20) zu bilden.

7. Verfahren nach Anspruch 6, wobei die leitenden Pads (35, 36) eine zentrale Aussparung (37, 38) gegenüber den Durchgangslöchern (146', 148") der erste Leiterplatte (21) und/oder der zweite Leiterplatte (22) aufweisen, die bestimmt sind, die Sacklöcher (146, 148) zu bilden.

8. Verfahren nach einem der Ansprüche 6 oder 7, wobei die leitenden Pads (35, 36) aus der vorherigen Gravur einer leitenden Schicht der dritte Leiterplatte (23) resultieren.

9. Verfahren nach einem der vorangehenden Ansprüche, wobei erste Durchgangslöcher (146') und/oder zweite Durchgangslöcher (148'), die bestimmt sind, die Sacklöcher (146, 148) zu bilden, eine metallische Beschichtung (46, 48) ihrer Wände aufweisen, die einen ersten Kragen (461, 481) aufweist, der sich auf den ersten Flächen (211, 221) der erste und zweite Leiterplatten (21, 22) erstreckt.

10. Verfahren nach einem der vorangehenden Ansprüche, wobei die Anordnung auf der ersten Kleberschicht (31) der ersten Fläche (211) der erste Leiterplatte (21) eine Platzierung der ersten Fläche der erste Leiterplatte (21) auf der ersten Kleberschicht (31) mit den ersten Durchgangslöchern (146'), die bestimmt sind, die Sacklöcher (146, 148) zu bilden, gegenüber den ersten materialfreien Zonen (41) und ein Pressen der erste Leiterplatte (21) auf die erste Kleberschicht (31) mit einer Erwärmung auf eine Temperatur zwischen 140 und 200°C umfasst; und/oder die Anordnung auf der zweiten Kleberschicht (32) der ersten Fläche (221) der zweite Leiterplatte (22) eine Platzierung der ersten Fläche (221) der zweite Leiterplatte (22) auf der zweiten Kleberschicht (32) mit den zweiten Durchgangslöchern (148'), die bestimmt sind, die Sacklöcher (146, 148) zu bilden, gegenüber den zweiten materialfreien Zonen (42) und ein Pressen der zweite Leiterplatte (22) auf die zweite Kleberschicht (32) mit einer Erwärmung auf eine Temperatur zwischen 140 und 200°C umfasst.

## Claims

1. A process for producing a backplane circuit board (20) having an internal face (142) adapted to be connected to connectors (13) of circuit boards (12) and an external face (143) adapted to be connected to an external connector (15), a series of first blind holes (146) opening on the one hand on the internal face (142) of the backplane circuit board (20) and a series of second blind holes (148) opening on the other hand on the external face (143) of the backplane circuit board (20), the backplane circuit board (20) comprising:
- a first printed circuit (21) having a first face and a second face designed to form the internal face (142) of the backplane circuit board (20);
- a second printed circuit (22) having a first face and a second face designed to form the external face (143) of the backplane circuit board (20) and;
- a third printed circuit (23) having a first face (231) facing the first face of the first printed circuit (21) and a second face (232) facing the first face of the second printed circuit (22), the third printed circuit (23) constituting an electrical insulator between its first face (231) and its second face (232), said first blind holes (146) passing through the first printed circuit (21) but not passing through the third printed circuit (23) and said second blind holes (148) passing through the second printed circuit (22) but not passing through the third printed circuit (23);
**characterised in that** the process comprises the following steps:
- depositing on the first face of the third printed circuit (23) of a first bonding layer (31), said first bonding layer (31) having first zones (41) cleared of material distributed on the first face (231) of the third printed circuit (23), and depositing on the second face (232) of the third printed circuit (23) of a second bonding layer (32), said second bonding layer (32) having second zones (42) cleared of material distributed on the second face (232) of the third printed circuit (23);
- assembling on the first bonding layer of the first face of the first printed circuit (21), said first printed circuit (21) having a series of first through-holes (146') designed to form the first blind holes (146), each first through-hole (146') opening in a first zone cleared of material of the first bonding layer (31) on the first face (231) of the third printed circuit (23) to form the first blind holes (146), and assembling on the second bonding layer of the first face of the second printed circuit (22), said second printed circuit (22) having a series of second through-holes (148') designed to form the second blind holes (148), each second through-hole (148') opening in a second zone (42) cleared of material of the second bonding layer (32) on the second face (232) of the third printed circuit (23) to form the second blind holes (148).

2. The process according to claim 1, wherein a first through-hole (146') has a diameter, and a first zone cleared of material in which said first through-hole (146') opens has a diameter greater than the diameter of the first through-hole (146') of at least 100 µm, and wherein a second through-hole (148') has a diameter, and a second zone cleared of material in which said second through-hole (148') opens has a diameter greater than the diameter of the second through-hole (148') of at least 100 µm.

3. The process according to any one of the preceding claims, wherein the adhesive material comprises a fabric impregnated with non-polymerised resin.

4. The process according to claim 3, wherein the resin has a dynamic viscosity greater than 5000 poises between 80°C and 180°C.

5. The process according to any one of the preceding claims, wherein the first bonding layer (31) has the first zones (41) cleared of material before its deposition on the first face (231) of the third printed circuit (23) and/or the second bonding layer (32) has the second zones (42) cleared of material before its deposition on the second face (232) of the third printed circuit (23).

6. The process according to any one of the preceding claims, wherein the third printed circuit (23) comprises first conductive pads (35) distributed on the first face, the first bonding layer (31) being arranged on the first face (231) of the third printed circuit (23) such that the first conductive pads (35) are in first zones (41) cleared of material of the first bonding layer (31), and after assembling said first conductive pads (35) face first through-holes (146') of the first printed circuit (21) to form the base of the first blind holes (146) of the internal face (142) of the backplane circuit board (20), and/or the third printed circuit (23) comprises second conductive pads (36) distributed on the second face (232) , the second bonding layer being arranged on the second face of the third printed circuit (23) such that the second conductive pads (36) are in second zones (42) cleared of material of the second bonding layer (32), and after assembling the second conductive pads (36) face second through-holes (148') of the second printed circuit (22) to form the base of the second blind holes (148) of the external face (143) of the backplane circuit board (20).

7. The process according to claim 6, wherein the conductive pads (35, 36) have a central recess (37, 38) opposite the through-holes (146', 148") of the first printed circuit (21) and/or of the second printed circuit (22) designed to form the blind holes (146, 148).

8. The process according to any one of claims 6 or 7, wherein the conductive pads (35, 36) result from previous etching of a conductive layer of the third printed circuit (23).

9. The process according to any one of the preceding claims, wherein first through-holes (146') and/or second through-holes (148') designed to form the blind holes (146, 148) have a metallic coating (46, 48) of their walls having a first flange (461, 481) extending on the first faces (211, 221) of the first and second printed circuits (21, 22).

10. The process according to any one of the preceding claims, wherein assembling on the first bonding layer (31) of the first face (211) of the first printed circuit (21) comprises placing of the first face of the first printed circuit (21) on the first bonding layer (31) with the first through-holes (146') designed to form the blind holes (146, 148) facing first zones (41) cleared of material, and pressing of the first printed circuit (21) on the first bonding layer (31) with heating at a temperature between 140 and 200°C, and/or assembling on the second bonding layer (32) of the first face (221) of the second printed circuit (22) comprises placing of the first face (221) of the second printed circuit (22) on the second bonding layer (32) with the second through-holes (148') designed to form the blind holes (146, 148) facing second zones (42) cleared of material, and pressing of the second printed circuit (22) on the second bonding layer (32) with heating at a temperature between 140 and 200°C.
